# EUROPEAN PATENT SPECIFICATION

(11) **EP 0 723 699 B1**
(45) Date of publication and mention of the grant of the patent: **12.12.2001**
(21) Application number: 95905841.3
(22) Date of filing: 17.10.1994
(51) Int. Cl.: H01J 17/16, H01J 61/12, H01J 61/30, H01J 65/04

(54) **ELECTRODELESS MAP WITH IMPROVED EFFICACY**
ELEKTRODENLOSE LAMPE MIT VERBESSERTER LEISTUNG
LAMPE SANS ELECTRODE A EFFICACITE AMELIOREE

(30) Priority: 15.10.1993 US 136078
(43) Date of publication of application: 31.07.1996
(73) Proprietor: FUSION LIGHTING, INC., Rockville, MD 20855 (US)
(72) Inventor: TURNER, Brian, Myersville, MD 21773 (US); KAMAREHI, Mohammad, N. Potomac, MD 20849 (US); LEVINE, Leslie, Bethesda, MD 20817 (US); URY, Michael, G., Bethesda, MD 20817 (US)
(74) Representative: Schwepfinger, Karl-Heinz, Dipl.-Ing.
(86) International application number: PCT/US94/11771
(87) International publication number: WO 95/10848

(56) References cited:
- WO-A-92/08240
- US-A- 3 234 421
- US-A- 4 247 798
- US-A- 4 485 332
- US-A- 4 501 993
- US-A- 4 507 587
- US-A- 5 151 633

## Description

The present invention is directed to a lamp for providing visible light as defined in the precharacterizing portion of claim 1.

Electrodeless lamps which are used for illumination applications, and which are powered by electromagnetic energy, including microwave and R.F., are known. It is also known that such lamps may include a fill where the emission is generated with sulfur or selenium, or a compound thereof. Such a lamp is disclosed in U.S. Application No. 071,027, filed June 3, 1993, and PCT International Publication No. WO 92/08240.

This document further discloses a bulb diameter of 2 to 3 cm, a fill pressure of at least 1 atmosphere and preferably 2 to 20 atmospheres at operating temperature and a power density of at least 50 watts/cc and preferably greater than 100 watts/cc.

Additionally, reference is made to US-A-5 151 633, which discloses an RF electrodeless lamp with sulfur included in the starter fill.

Fom US-A-3 234 421 and from US-A-4 247 798 it is known to add selenium and tellurium in a metal halid lamp with inner electrodes.

US-A-4 501 993 discloses a microwave excited electrodeless lamp and mentions selenium and tellurium as additives to the quartz of the envelope.

US-A-4 485 332 and US-A-4 507 587 disclose a microwave excited electrodeless lamp and power density for UV emission.

As is well known, an important figure of merit of lamp performance is efficacy, i.e., the visible light output as compared to the electrical power inputted to the lamp, as this determines the cost of operating the lamp. The lamp disclosed in the above-mentioned PCT Publication is of a type having a high efficacy. In accordance with the present invention, it has been found that the efficacy of such a lamp can be improved still further to a substantial extent by operating the lamp in a specific regime.

In accordance with the present invention, a lamp as defined in the precharacterizing portion of claim 1 also comprises the features of the characterizing portion of claim 1.

Providing a large volume to surface area ratio minimizes the heat which is lost through the wall of the lamp envelope. Since the electrical power inputted is converted to either light or heat, increasing the volume to surface area ratio has the effect of increasing the efficiency of light emission. In the case of a spherical envelope, the volume to surface area ratio is increased by increasing the diameter of the envelope.

Operation in a regime wherein the ratio of volume to outer surface area of the lamp envelope is at least .45 cm, the concentration of the sulfur, selenium, or tellurium during operation is less than 1.75 mg/cc, and the power density is less than 100 watts/cc and greater than 5 watts/cc produces the unexpected result of a substantial improvement in efficacy.

The invention as claimed will be better appreciated in accordance with the accompanying figures, wherein:
Figure 1 is a perspective view of an embodiment of the invention.
Figure 2 is a side view of the embodiment of Figure 1.
Figure 3 is a spectrum of emitted light using a sulfur fill.
Figure 4 is a spectrum of emitted light using a selenium fill.
Figure 5 is a spectrum of emitted light using a tellurium fill.

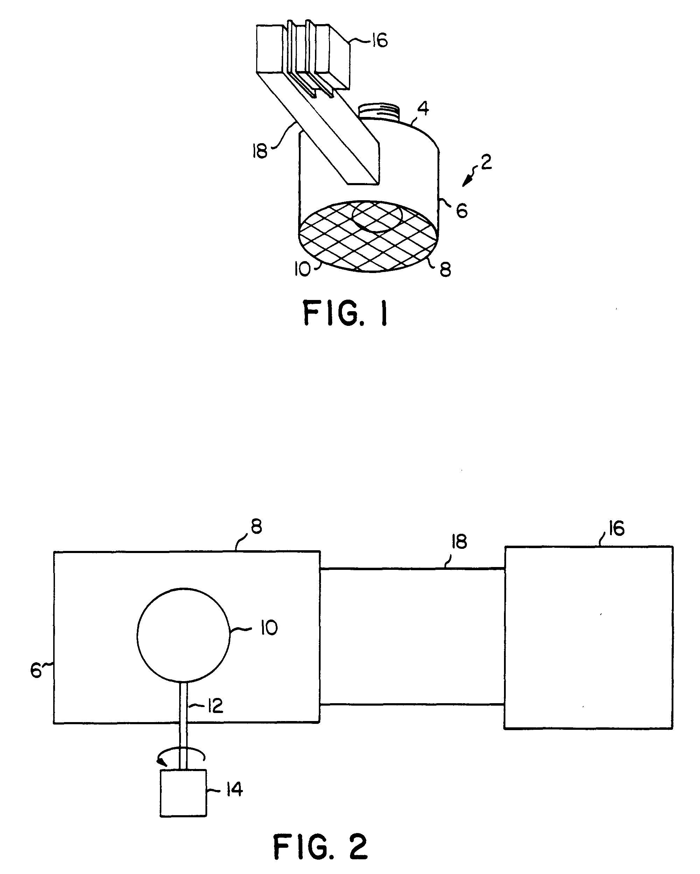

Referring to Figure 1, lamp 2 is depicted which is an embodiment of the invention as claimed which is powered by microwave energy, it being understood that R.F. energy may be used as well.

Lamp 2 includes a microwave cavity 4 which is comprised of metallic cylindrical member 6 and metallic mesh 8. Mesh 8 is effective to allow the light to escape from the cavity while retaining the microwave energy inside.

Bulb 10 is disposed in the cavity, which in the embodiment depicted is spherical. Referring to Figure 2, the bulb is supported by stem 12, which is connected with motor 14 for effecting rotation of the bulb. This rotation promotes stable operation of the lamp.

Microwave energy is generated by magnetron 16, and waveguide 18 transmits such energy to a slot (not shown) in the cavity wall, from where it is coupled to the cavity and particularly to the fill in bulb 10.

Bulb 10 consists of a bulb envelope and a fill in the envelope. The fill includes sulfur, selenium, or tellurium, or a compound of one of these substances. Examples of substances which may be used in the fill are InS, As₂S₃, S₂Cl₂, CS₂, In₂S₃, SeS, SeO₂, SeCl₄, SeTe, SCe₂, P₂Se₅, Se₃As₂, TeO, TeS, TeCl₅, TeBr₅, and TeI₅.

Additionally, other sulfur, selenium, and tellurium compounds may be used, for example those which have a relatively low vapor pressure at room temperature, i.e., they are in solid or liquid state, and a vapor pressure at operating temperature which is sufficient to maintain useful light output.

In accordance with an aspect of the invention as claimed, the ratio of the volume to outer surface area of the lamp envelope is at least .45 cm. As discussed above, this promotes high efficacy. The preferred ratio of volume to outer surface area is above .6 cm. As used herein, the "surface area" in the term "volume to surface area" refers to the outside surface area of the bulb envelope (the volume being internal to the inside surface area).

Additionally, the concentration of the sulfur, selenium, or tellurium during operation is below 1.75 mg/cc and the power density is below 100 watts/cc and above 5 watts/cc.

It is notable that the lamp of the invention as claimed achieves operation at power densities which are below 20 watt/cc. The term "power density" refers to the power inputted to the bulb divided by the bulb volume. One may employ in the lamps of the invention as claimed any fill including one or a combination of fill materials which, at lamp operating temperature and at the selected power density, yields sufficient concentration of sulfur, selenium, and/or tellurium in the envelope to provide useful illumination.

The lamp may output a reduced amount of spectral energy in the infrared, and spectral shifts with variations in power density have been observed. Forced air cooling may be required at higher power densities.

### Example I

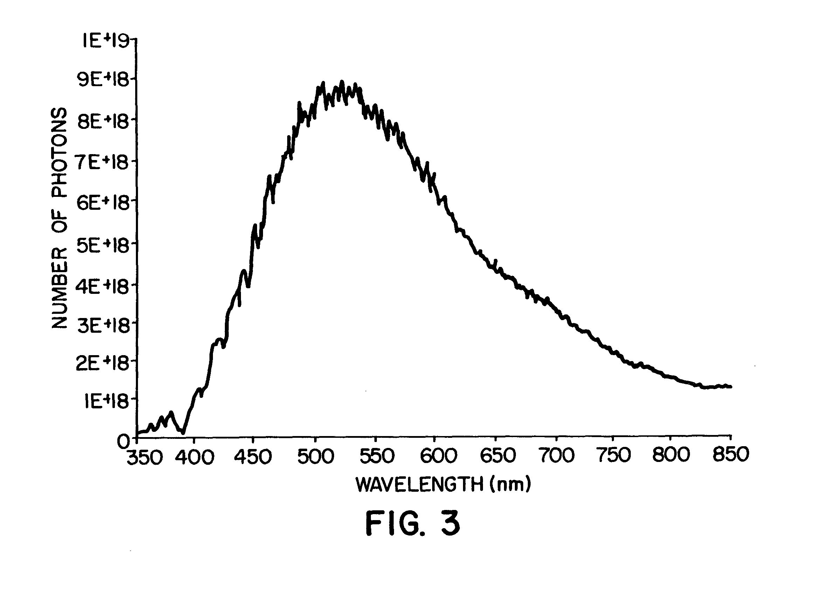

In a specific embodiment of the invention as claimed which was tested, a spherical bulb of outside diameter 4.7 cm (wall thickness of 1.5 mm) was used, resulting in a volume to surface area ratio of .64 cm. The applied power was 1100 watts, the fill was sulfur at a concentration of 1.3 mg/cc, resulting in a power density of 19.5 watts/cc, and the bulb was rotated at 300 RPM. Visible light was produced having a spectrum as shown in Figure 3. The average efficacy around the bulb was 165 lumens/watt (microwave watt). The ratio of the visible spectral power produced to the infrared spectral power was 10 to 1. As is typical in lamps of this general type, the fill included an inert gas, specifically 20 kPa (150 torr) of argon.

### Comparison (Example I)

In the example in the above-mentioned PCT Publication having a "sulfur only" fill, an electrodeless quartz bulb of spherical shape having an internal diameter of 2.84 cm, (O.D. 30 mm), and a volume to outer surface area ratio of .43 cm, was filled with .062 mg-moles/cc (1.98 mg/cc) of sulfur, and 8 kPa (60 torr) of argon. When excited with microwave energy at a power density of about 280 watts/cc, the efficacy around the lamp was 140 lumens/watt.

### Example II

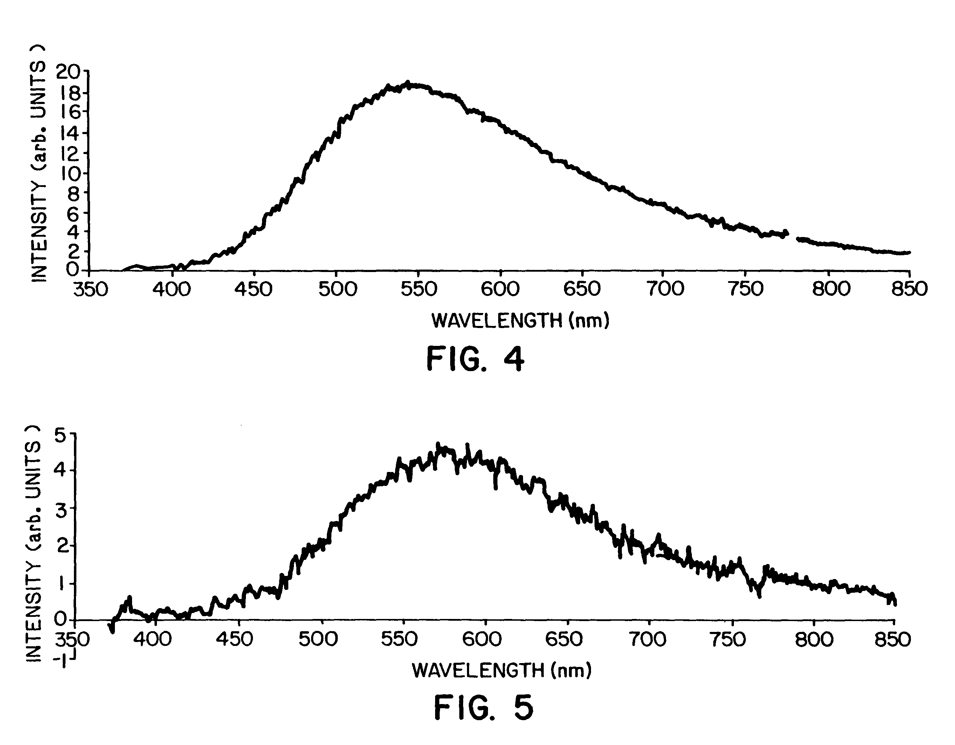

A spherical bulb of diameter 40 mm OD (37 mm ID), resulting in a volume to surface area ratio of .53 cm was filled with 34 mg of Se, and 40 kPa (300 torr) of xenon gas, resulting in a selenium concentration of 1.28 mg/cc. The lamp was powered by 1000 microwave watts inside a resonant cavity. Visible light was produced having a spectrum as shown in Figure 4. The average efficacy around the bulb exceeded 180 lumens/watt.

### Comparison (Example II)

As disclosed in the above-mentioned PCT Publication, an electrodeless quartz bulb having a volume of 12 cc (wall thickness of 1.5 mm) was filled with 54 mg of selenium and with 8 kPa (60 torr) of argon. The bulb was placed in a microwave cavity and excited with 3500 watts of microwave energy. The average efficacy around the bulb was about 120 lumens/watt.

As can be seen by referring to the above examples, a substantial improvement in efficacy is achieved by operating in the regime which is taught herein.

### Example III

A spherical bulb of 40 mm OD (37 mm ID) resulting in a volume to surface area ratio of .53 cm was filled with 20 mg of tellurium and 13.3 kPa (100 torr) of xenon, resulting in a tellurium concentration of .75 mg/cc. The lamp was powered with about 1100 watts inside a microwave cavity. Visible light was produced having a spectrum as shown in Figure 5. The average efficacy around the bulb was at least 105 lumens/watt.

A lamp having improved efficacy has been disclosed. While the invention has been disclosed in connection with preferred and illustrative embodiments, it should be understood that variations of this invention may occur to those skilled in the art, and the invention is to be limited only by the scope of the claims appended hereto .

## Claims

1. A lamp for providing visible light, comprising:
a lamp envelope (10) of light transmissive material;
a fill disposed in the envelope including at least one member selected from the group including sulfur and selenium wherein said at least one member is the primary visible light emitter at the operating temperature of the lamp;
wherein the at least one selected member is present at a concentration of les than 1.75 mg/cc; and
means (4, 16, 18) for coupling electromagnetic energy to the fill at a power density sufficient to cause the selected member to emit visible light from the envelope, **characterized in that** the group consists of sulfure and selenium and tellurium,
the lamp envelope has a ratio of volume to outer surface area of at least 0.45 cm,
and the power density is between 5 watts/cc and 100 watts/cc.

2. The lamp of claim 1, wherein the selected member is sulfur.

3. The lamp of claim 1, wherein the selected member is selenium.

4. The lamp of claim 1, wherein the selected member is tellurium.

5. The lamp of any of claims 2 to 4, wherein the ratio of volume to outer surface area is at least 0.6 cm.

6. The lamp of claim 1, wherein the electromagnetic energy is microwave energy.

## Patentansprüche

1. Lampe zur Erzeugung von sichtbarem Licht, umfassend:
ein Lampengehäuse (10) aus lichtdurchlässigem Material;
eine in dem Gehäuse befindliche Füllung, die wenigstens ein Element enthält, das aus der Gruppe ausgewählt ist, die Schwefel und Selen enthält, wobei das wenigstens eine Element der primäre Strahler des sichtbaren Lichts bei der Betriebstemperatur der Lampe ist;
wobei das wenigstens eine ausgewählte Element in einer Konzentration von weniger als 1,75 mg/cc vorliegt; und
Mittel (4, 16, 18), um elektromagnetische Energie mit einer Leistungsdichte in die Füllung einzukoppeln, die ausreicht, um das ausgewählte Element zur Aussendung von sichtbarem Licht von dem Gehäuse anzuregen, **dadurch gekennzeichnet, daß**
- die Gruppe aus Schwefel und Selen und Tellur besteht,
- das Verhältnis von Volumen zu Außenoberfläche des Lampengehäuses wenigstens 0,45 cm beträgt, und
- die Leistungsdichte zwischen 5 Watt/cc und 100 Watt/cc aufweist.

2. Lampe nach Anspruch 1, wobei das ausgewählte Element Schwefel ist.

3. Lampe nach Anspruch 1, wobei das ausgewählte Element Selen ist.

4. Lampe nach Anspruch 1, wobei das ausgewählte Element Tellur ist.

5. Lampe nach einem der Ansprüche 2 bis 4, wobei das Verhältnis von Volumen zu Außenoberfläche wenigstens 0,6 cm beträgt.

6. Lampe nach Anspruch 1, wobei die elektromagnetische Energie Mikrowellenenergie ist.

## Revendications

1. Lampe pour produire de la lumière visible, comprenant :
un boîtier (10) de lampe en matériau translucide ;
un remplissage situé dans le boîtier, qui contient au moins un élément choisi parmi le groupe contenant du soufre et du sélénium, ledit au moins un élément étant le premier émetteur de lumière visible à la température de fonctionnement de la lampe ;
ledit au moins élément choisi étant en présence dans une concentration de moins de 1,75 mg/cc, et
des moyens (4, 16, 18) pour coupler de l'énergie électromagnétique au remplissage avec une puissance volumique qui est suffisante pour inciter l'élément choisi à émettre de la lumière visible depuis le boîtier, **caractérisé en ce que**
le groupe consiste en du soufre et en du sélénium et en du tellure,
le rapport entre le volume et la surface extérieure du boîtier de lampe est d'au moins 0,45 cm, et
la puissance volumique est de 5 Watt/cc et 100 Watt/cc.

2. Lampe selon la revendication 1, dans laquelle l'élément choisi est du soufre.

3. Lampe selon la revendication 1, dans laquelle l'élément choisi est du sélénium.

4. Lampe selon la revendication 1, dans laquelle l'élément choisi est du tellure.

5. Lampe selon l'une des revendications 2 à 4, dans laquelle le rapport entre le volume et la surface extérieure est d'au moins 0,6 cm.

6. Lampe selon la revendication 1, dans laquelle l'énergie électromagnétique est de l'énergie hyperfréquence.
